(19) Europäisches Patentamt
European Patent Office
Office européen des brevets

(11) **EP 2 400 311 A1**

(12) **EUROPEAN PATENT APPLICATION**

(43) Date of publication:
**28.12.2011 Bulletin 2011/52**

(51) Int Cl.:
***G01R 29/08*** (2006.01)   ***G01R 29/10*** (2006.01)
***H04B 17/00*** (2006.01)

(21) Application number: **10305691.7**

(22) Date of filing: **28.06.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(71) Applicant: **Thomson Licensing
92130 Issy-les-Moulineaux (FR)**

(72) Inventors:
• **Pintos, Jean-François
92443, Issy-Les-Moulineaux (FR)**

• **Abdelhakim, Youcef
92443, Issy-Les-Moulineaux (FR)**
• **Louzir, Ali
92443, Issy-Les-Moulineaux (FR)**

(74) Representative: **Le Dantec, Claude
Technicolor
1-5 rue Jeanne d'Arc
92130 Issy-les-Moulineaux (FR)**

(54) **Device for representing angular energy distribution of a wireless radio frequency propagation channel and corresponding method**

(57)   The invention proposes a device and method for representing angular distribution of a wireless radio frequency propagation channel. Among others, the invention allows to represent angular energy distribution of a wireless radio frequency propagation channel as related to a radiation pattern of an antenna system comprising one or more antennas.

Fig. 13

**Description**

**1. Field of invention.**

The present invention relates to the field of wireless radio frequency (RF) communications. In particular, the present invention relates to a device and method for representing angular energy distribution of a wireless RF propagation channel according to an angular distribution model, in order to allow optimization of transmission and reception performances of wireless RF transmitter and/or receiver systems.

**2. Technical background.**

The performance of a transmission/reception system is strongly influenced by the environment in which the system operates. In an urban environment for example, radio waves are obstructed and reflected by the buildings that surround the transmitter and the receiver. This causes attenuation of the transmitted signal and time-shifted or delayed reception of multiple copies of the transmitted signal, received via reflection via multiple paths. A receiver receives multiple copies of a transmitted signal via multiple paths, which interfere in a constructive or a destructive manner and affect the quality of reception. The means for propagation of transmitted signals to the receiver is called a propagation channel. A major point is that the performance of a receiver depends essentially on the nature of the propagation channel in which it operates. For example, for a satellite reception, the propagation channel needs to be free of obstacles, i.e. the transmitter and receiver must be in line of sight. By contrast, for a MIMO-based reception (Multiple-Input and Multiple Output, an antenna technology that exploits the use of multiple antennas to improve communication performance), the richness of the multi path reception in the propagation channel is exploited for improvement of the receiver's performance. The study and modeling of the propagation channel are thus key elements for designing a wireless communication system, in order to efficiently exploit the transmission capacity of the propagation channel. A particular matter of interest is the study of angular distribution of radio waves in the propagation channel, which is done with the help of statistical and graphical representations. Such studies of propagation channels allow for example, to determine mean angles of signal arrival/departure (hereinafter also referred to as AoA (Angle of Arrival) and AoD (Angle of Departure)), angular power/energy dispersion, and distribution of radio waves in horizontal (azimuth) and vertical (elevation) angular directions.

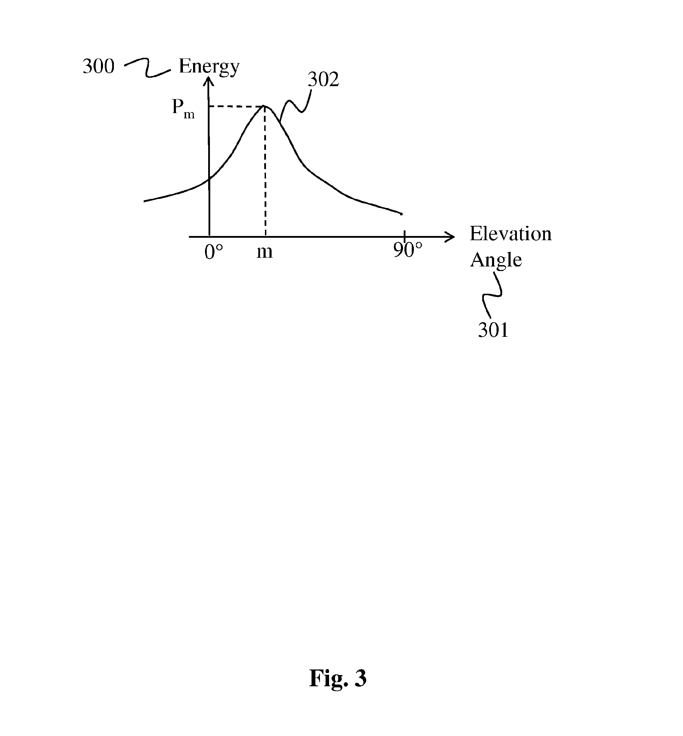

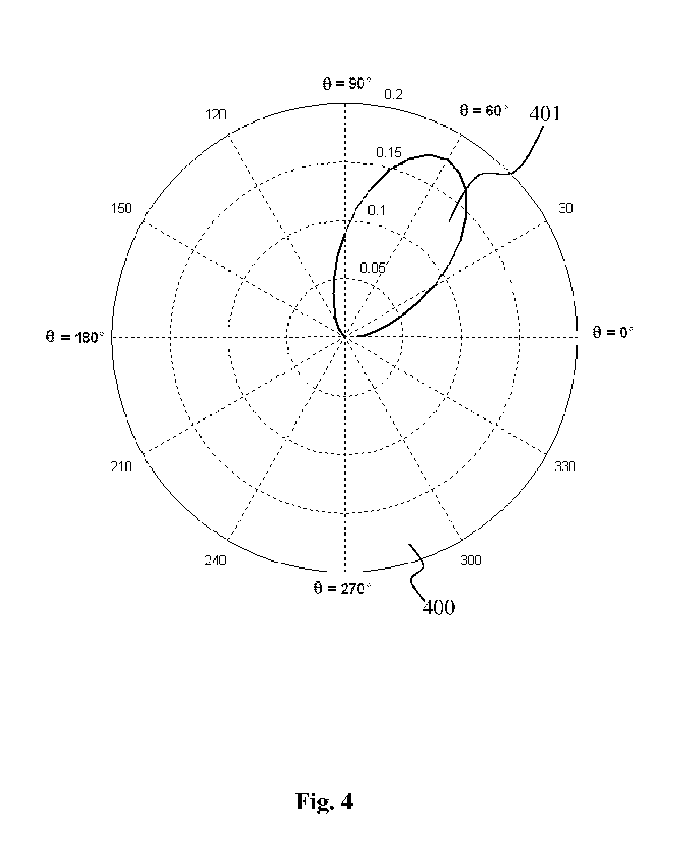

Numerous publications present the propagation channel in a statistical form with associated mathematical rules. These mathematical rules are often determined by large-scale measuring campaigns. Data related to the statistical energy distribution in the propagation channel as a function of angle of arrival or angle of departure, thus obtained, are then presented in graphical form, which helps in understanding the said data, i.e. the characteristics of the propagation channel, and which thus helps in designing transmitter and/or receiver systems that are to operate in the propagation channel. Figs. 3 and 4 give examples of such prior art graphical representations. The graphical representation of Fig.3 shows a prior-art representation of average energy related to elevation angle according to a Cartesian representation of a Gaussian distribution model. This representation is fairly simple and allows getting a general idea of the mean arrival angle of incident waves, and their angular energy dispersion. However, this representation does not show the angular energy dispersion in the orthogonal plane, here the azimuth plane, since the diagram only shows the angular energy dispersion in the elevation plane. As it does not allow representing all information, the visible information is partial. The prior-art graphical representation of Fig.4 represents a section of energy dispersion in the elevation plane of a Gaussian distribution model according to polar representation. As for figure 3, the represented information is partial, as it does not show the angular energy dispersion in the orthogonal plane.

The current prior art solutions of representation of angular energy distribution of a wireless RF propagation channel are thus not optimized.

**3. Summary of the invention.**

The invention proposes a device and method for representing angular energy distribution of a wireless RF propagation channel.

Among others, the invention allows to represent angular energy distribution of a wireless radio frequency propagation channel related to a radiation pattern of an antenna system in a same 2D or 3D illustration. Among the advantages procured by the invention when compared to prior art solutions, are that the invention eases optimization of transmitter/receiver design and/or eases automatic optimization of transmitter/receiver antenna systems to propagation channel characteristics and antenna system radiation patterns. These advantages and other advantages not mentioned here but that will become clear through the detailed description of the invention that follows make the device and method of the invention advantageously well suited for representation of angular energy distribution of a wireless RF propagation channel.

In order to optimize transmission in a transmission system and/or reception in a reception system, the invention proposes a method for representing angular energy distribution of a wireless RF propagation channel, the method representing angular energy distribution data as related to radiation pattern data of an antenna system that comprises one or more antennas, the method comprising a step of generating a polar representation of the angular energy distribution data in an azimuth plane, in an elevation plane, or in both the azimuth and elevation plane, the polar representation being presented in a first zone of one or more sections of a spherical geometrical form, the polar representation being oriented according to a predetermined angular reference; and a step of generating, in the one or more sections of the spherical geometrical form, of a representation of radiation pattern data of the antenna system as oriented according to the predetermined angular reference.

According to a variant embodiment of the invention, the method further comprises a step of representing the radiation pattern data of the antenna system in a second zone centered in an origin of the one or more sections of the spherical geometrical form; the first zone being situated around the second zone, the first zone being centered in the origin of the one or more sections of the spherical geometrical form.

According to a variant embodiment of the invention, the polar representation of the angular energy distribution data is determined according to one or more predetermined mathematical functions applied to the angular energy distribution data.

According to a variant embodiment of the invention, the method further comprises a step of rendering of an empty zone between the first zone and the second zone, the empty zone being centered in the origin of the one or more sections of the spherical geometrical form.

In order to optimize transmission in a transmission system and/or reception in a reception system, the invention also concerns a device for representation of angular energy distribution data of a wireless radio frequency propagation channel, the device representing the angular energy distribution data as related to radiation pattern data of an antenna system comprising one or more antennas, the device comprising means for generating a polar representation of the angular energy distribution data in an azimuth plane, in an elevation plane, or in both azimuth and elevation planes, the polar representation being presented in a first zone of one or more sections of a spherical geometrical form, the polar representation being oriented according to a predetermined angular reference; and means for generating in the one or more sections of the spherical geometrical form of a representation of the radiation pattern data of the antenna system as oriented according to the predetermined angular reference.

According to a variant embodiment of the device of the invention, the device further comprises means for representing the radiation pattern data of the antenna system in a second zone centered in an origin of the one or more sections of the spherical geometrical form, and means for rendering the first zone around the second zone, the first zone being centered in the origin of the one or more sections of said spherical geometrical form (803, 1300).

According to a variant embodiment of the device of the invention, the polar representation of the angular energy distribution data is determined by determination means according to one or more predetermined mathematical functions applied to the angular energy distribution data.

## 4. List of figures.

More advantages of the invention will appear through the description of particular, non-restricting embodiments of the invention. The embodiments will be described with reference to the following figures:

**Figure 1** shows essential components of a wireless RF communication system and illustrates the notion of propagation channel.
**Figure 2** shows how signals that are transported over the propagation channel are subject to radio wave scattering.
**Figure 3** shows a prior-art Cartesian representation of a Gaussian distribution model of energy propagation in a typical propagation channel such as the propagation channels of figs. 1 and 2.
**Figure 4** shows a prior-art polar representation of a Gaussian distribution model of energy propagation in a typical propagation channel such as the propagation channels of figs. 1 and 2.
**Figure 5** shows a corrected representation of the prior-art polar representation of figure 4 that takes into account the energy distribution mirrored in the orthogonal plane.
**Figure 6** shows a variant representation of the data that served for figure 5 according to a Cartesian normalized representation of a Gaussian distribution model.
**Figure 7** shows the representation of figure 6 after application of a mathematical inverse function.
**Figure 8** shows a representation template of angular energy distribution according to a particular embodiment of the invention.
**Figure 9** shows how the curves of figure 7 are represented in a zone of a diagram according to the template representation of figure 8 with new angle pairing.
**Figure 10** shows integration of radiation pattern data of an antenna system into a diagram according to the template representation of figure 8.

**Figure 11** shows an adaptation of the antenna system of a receiver-or transmitter system to the energy distribution characteristics of the propagation channel.

**Figure 12** illustrates an example of a device implementing an automatic optimization of an antenna system based on a particular implementation of the invention.

**Figure 13** shows a 3D representation of angular energy distribution in a propagation channel according to a particular embodiment of the invention.

**Figure 14** shows another example of a 3D representation according to a particular embodiment of the invention.

**Figure 15** shows a device implementing the invention according to a particular embodiment of the invention.

**Figure 16** shows an algorithm of a method according to the invention for representing angular energy distribution of a wireless radio frequency propagation channel. The method is for example implemented by the device of figure 1515.

**5. Detailed description of the invention.**

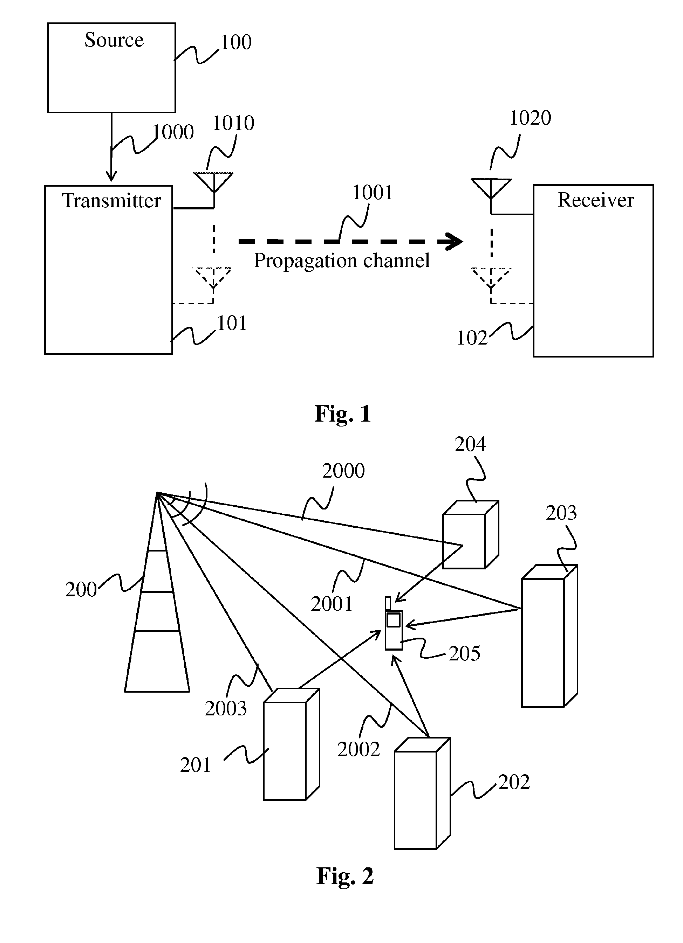

**Figure 1** shows the essential components of a wireless RF communication system. The RF communication system comprises an information source 100, which provides information that a transmitter 101 modulates on a radio frequency carrier, and which is output via an antenna system 1010 comprising one or more antennas to a receiver 102 comprising an antenna system 1020 with one or more antennas, where the information signal is demodulated. The propagation of the wireless signals takes place over a propagation channel 1001 between transmitter 101 and receiver 102. Of course, such system may comprise multiple receivers and/or transmitters.

**Figure 2** shows how the signals that are transported over the propagation channel encounter a certain number of constraints and propagation phenomena that influence their reception. A same signal transmitted by a transmitter with and antenna system 200 is received as multiple signals 2000-2003 by the antenna system of receiver 205 through scattering of radio waves by buildings 201-204, which cause energy dispersion and signal diffraction. A typical receiver in such a propagation channel receives multiple time-shifted or delayed copies of a same signal. In order to optimize the transmission and reception of the information signal, it is essential to know the nature of the propagation channel.

**Figure 3** shows a prior-art Cartesian representation of a Gaussian distribution model of energy propagation in a typical propagation channel, where energy propagation level 300 is related to elevation angle 301. The representation does not show energy propagation in the orthogonal (here: azimuth) plane. The information represented is partial.

**Figure 4** shows another prior-art polar representation of a Gaussian distribution model of energy propagation in a typical propagation channel, where, as in figure 3, the energy propagation level is related to the elevation plane. The energy propagation is represented as a lobe 401 in a polar representation 400. The radius represents the average distribution power that increases from the center of the diagram to the outside. The representation does not take into account the energy propagation in the orthogonal (azimuth) plane. The information represented is therefore partial. The parameters for this representation are:

For the Gaussian elevation distribution model:

$$P_T(\theta) = A_\theta . exp\left[ -\frac{(\theta - m)^2}{2\,\sigma^2}\right]$$

For the uniform azimuth distribution model:

$$P_T(\varphi) = 1$$

Where $P_T$ represents the total power of the incident wave, and $\theta$ represents the elevation angle $\theta \in [0, \pi]$ and $\varphi$ represents the azimuth angle $\varphi \in [0, 2\pi]$

Statistical Environment parameters:

- Mean Angle of Arrival: $m = \frac{\pi}{3} = 60°$

- Standard deviation (Angular spread): $\sigma = \frac{\pi}{7} \approx 25.7°$

- $A_T = 0.1522$ when $A_\theta$ is a constant determined by the following integral:

$$\int_0^{2\pi} \int_0^{\pi} P_T(\theta,\varphi)\sin\theta \; d\theta \; d\varphi \; = \; 1$$

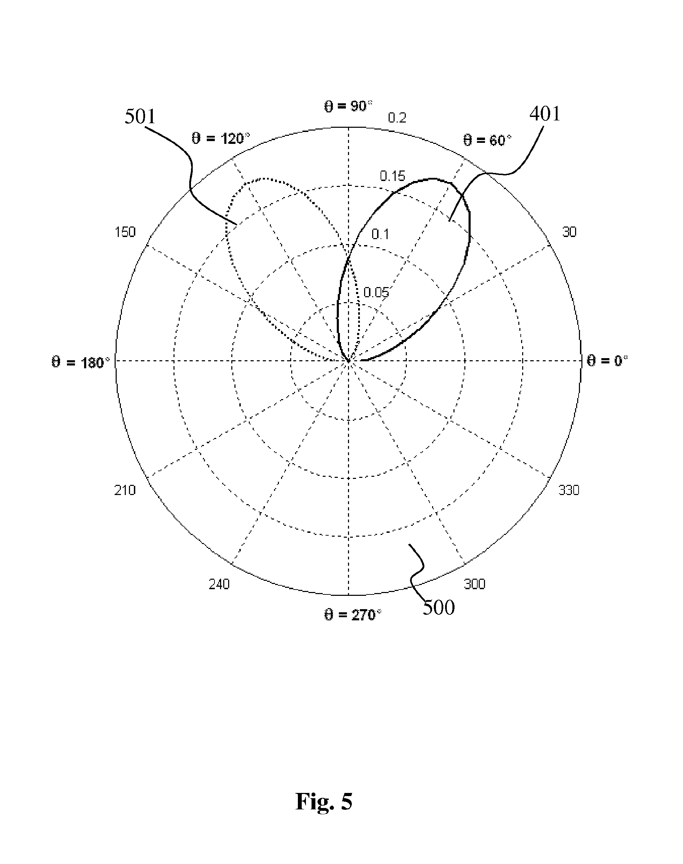

**Figure 5** shows a corrected representation of the prior-art polar representation of figure 4, that takes into account the energy distribution mirrored in the orthogonal plane, which gives a more realistic picture of the energy distribution. The energy distribution in the orthogonal (azimuth) plane is supposed to be uniform. As can be seen, not only the energy is distributed in a first lobe 401 at θ = 60° elevation, but the representation shows a second identical lobe 501 at θ = 120° elevation. This can be best understood if one realizes that figure 5 pictures a slice from a 3D representation where the energy distribution can be seen as a cone with a V-form, where the walls of the cone have the forms of the lobes. The parameters for this representation are the same as for figure 4.

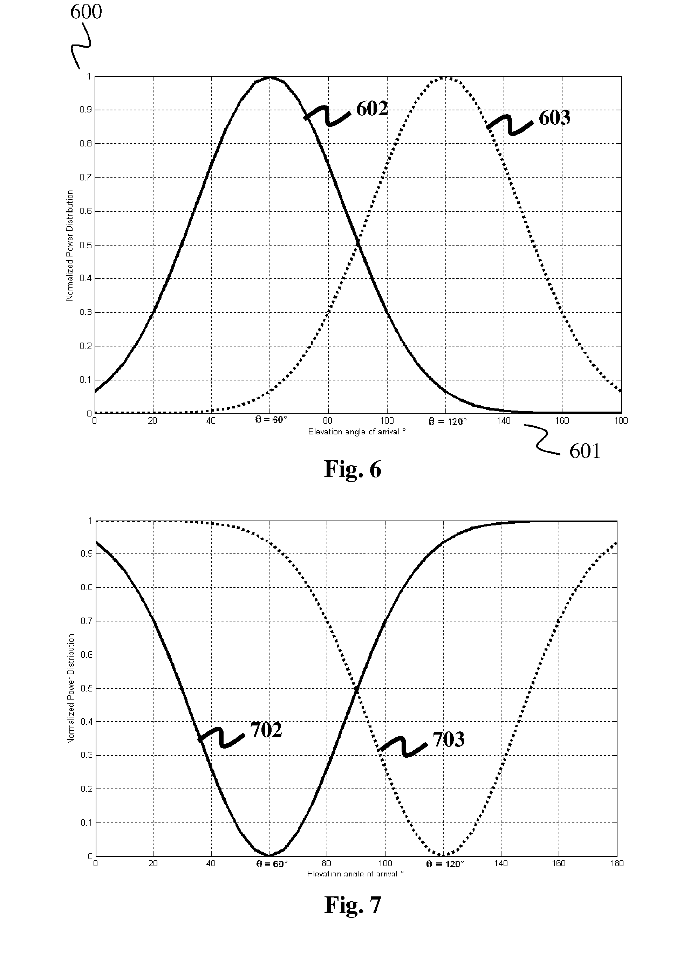

**Figure 6** shows a variant representation of the energy distribution data that served for representing figure 5 in a Cartesian representation of Gaussian energy distribution model where energy level is related to elevation angle and normalized. The figure shows two curves 602 and 603 that correspond to the energy distribution lobes 401 respectively 501 of figure 5. Energy distribution level is represented on a vertical Y axis 600, whereas elevation angle θ is represented on a horizontal X axis 601 according to:

Normalized Power Distribution Values

$$X(\theta) = \theta \quad \text{with } \theta \in [0, 180°]$$

$$Y(\theta) = P_T(\theta)_N = {P_T(\theta)} / {P_T max}$$

Statistical Environment parameters:

- Mean Angle of Arrival: $m = \dfrac{\pi}{3} = 60°$

- Standard deviation (Angular spread): $\sigma = \dfrac{\pi}{7} \approx 25.7°$

**Figure 7** shows the diagram of figure 6 after application of a mathematical inversion function f(x) = 1 — p, p being the energy level. The parameters for this representation are:

$$X(\theta) = \theta \quad \text{with } \theta \in [0, 180°]$$

$$Y(\theta) = P_T(\theta)_{N_{Inverted}} = 1 - P_T(\theta)_N$$

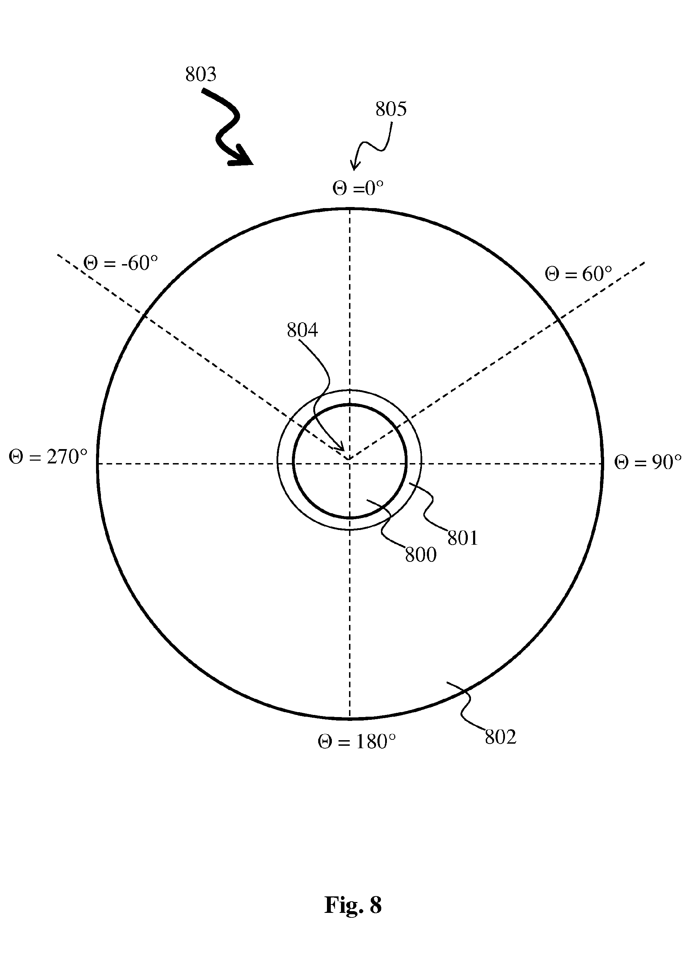

**Figure 8** shows a representation template for representation of angular energy distribution of a wireless radio frequency propagation channel according to a particular embodiment of the invention. The figure shows a section of a spherical geometrical form 803 that comprises a first zone 802 for polar representation of angular energy distribution data and a second zone 800 for representation of antenna radiation pattern data of an antenna system comprising one or more antennas. An optional empty zone 801 improves the readability of the figure. The angular reference system used is different from previously presented polar representations of figures 4 and 5, i.e. θ=0° at the top of the figure (reference 805) in order to adapt the representation to the angular reference system commonly used for representing antenna energy radiation patterns.

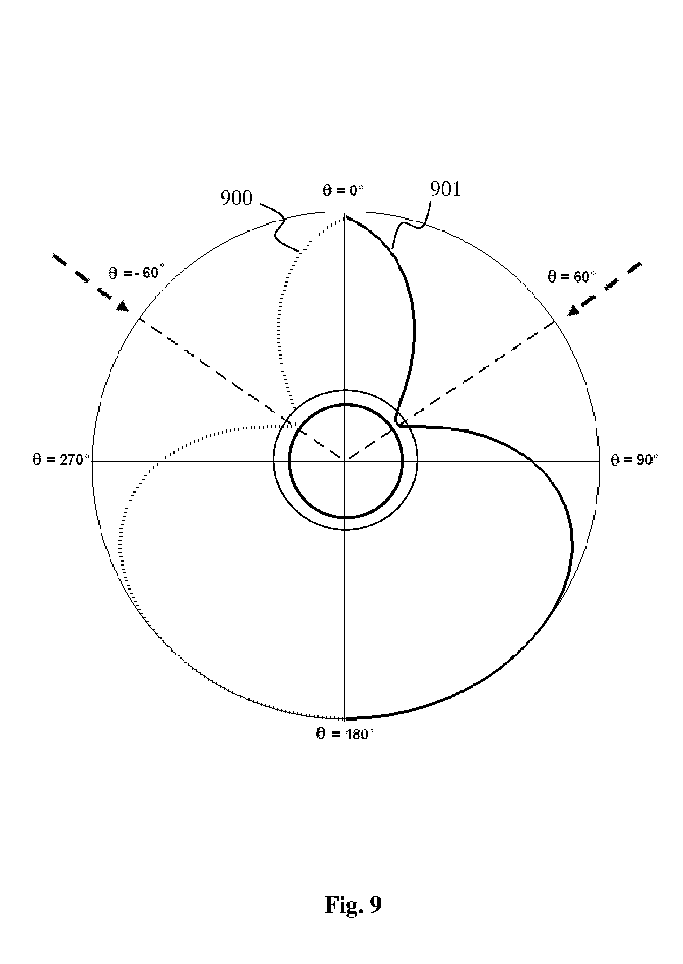

**Figure 9** shows how the curves of figure 7 are represented in the first zone 802 of a diagram according to the template of figure 8 according to a particular embodiment of the invention. Here we find a first curve 901 with a maximum energy propagation level at θ=60°. This curve corresponds to curve 702 of the inversed-Cartesian representation of figure 7. A second curve 900 corresponds to a second maximum energy propagation level at θ=120°. This curve corresponds to curve 703 of the inversed-Cartesian representation of figure 7. The parameters for this figure are:

$$X\ (\theta) = \begin{cases} P_T(\theta)_{N_{Inverted}} . sin(\theta)\ for\ \ \theta \in [0, \pi] \\ -P_T(\theta)_{N_{Inverted}} . sin(\theta) for\ \ \theta \in [-\pi, 0] \end{cases}$$

$$Y\ (\theta) = P_T(\theta)_{N_{Inverted}} . cos(\theta) \qquad For\ \ \ \theta \in [0, 2\pi]$$

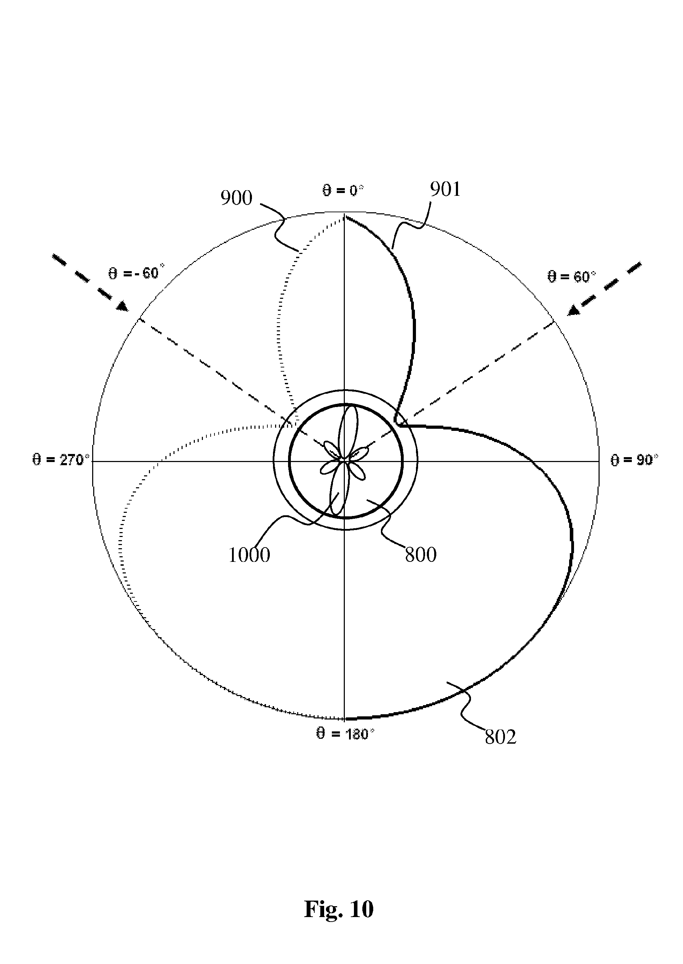

**Figure 10** shows integration of radiation pattern data of an antenna system comprising one antenna into a diagram according to the template representation of figure 8 according to a particular embodiment of the invention. A radiation pattern 1000 of a particular antenna system is represented in second zone 800. Since the radiation pattern 1000, which is represented in the in second zone 800, uses the same angular reference as the angular energy propagation curves 900 and 901 in the first zone 802, figure 10 allows to determine that the antenna system is not optimized with regard to the angular energy distribution in the propagation channel. The largest of the six lobes of the radiation pattern 1000 point approximately to elevation angles of 5° respectively 185°, where the energy distribution in the propagation channel is the lowest.

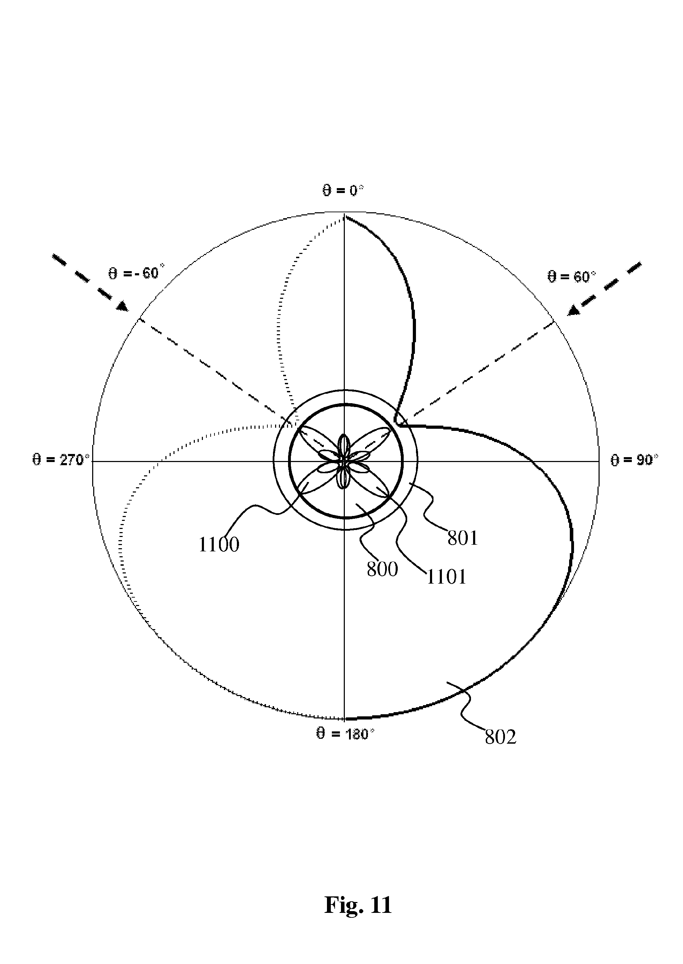

**Figure 11** shows an example of an antenna system that is, by means of analysis of figure 10, better optimized to the angular energy distribution in the propagation channel than the antenna system of figure 10. The antenna system is that of a receiver, such as receiver 102 of figure 1 or is that of a transmitter, such as transmitter 101 of figure 1. It is part of a MIMO system comprising two antennas, one of the antennas with radiation pattern 1100 having a particular sensitivity in the 60° elevation level, and the other with radiation pattern 1101 in the -60° (or 300°) elevation level. The antenna system can be further optimized by reducing the antenna sensitivity in the elevation angles where the angular energy distribution of the propagation channel is low or where the energy is coming from an interfering (undesired) signal, in order to suppress noise or interferences from radio frequencies that do not belong to the desired signal (for a receiver) or to reduce emission of RF signal in directions that do not correspond to the angular energy distribution in the propagation channel (for a transmitter). Another optimization of the antenna system that can be determined from the representation of figures 10/11 comprises widening the opening angle of the antennas in order to make the antenna system less sensitive to orientation. The figure further shows that the angular energy distribution data is represented in a first zone 802, and that the antenna system radiation pattern is represented in a second zone 800 and that there is an optional third empty zone 801. The center of the polar representation is the origin 804 of the shown section of the spherical geometrical form 803, as can be observed in the template representation of figure 8.

The means of optimization can be either manually, by intervention in the design phase of an antenna system, or automatically, by intervention in the configuration of an antenna system. According to a variant embodiment of the invention, the representation of angular energy distribution in a propagation channel is interpreted automatically in order to adapt switch settings in a MIMO type antenna system so that only those antennas are selected of which the radiation patterns correspond to the maximum energy distribution angle(s) of the propagation channel. According to a variant embodiment of the invention, the optimization of an antenna system is done automatically by modification/selection of radiation pattern through known beam forming techniques and/or by selection of specific antennas of the antenna system. This can then be coupled to a Received Signal Strength Indication (RSSI) available on most digital/RF chips.

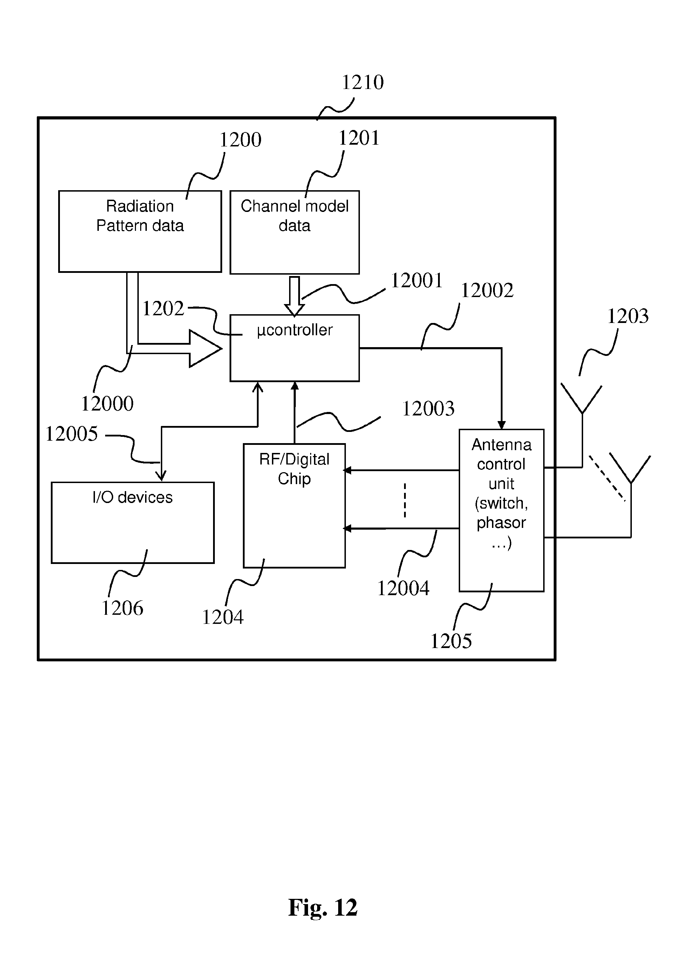

**Figure 12** illustrates an example of a device 1210 implementing such previously discussed automatic optimization. The device 1210 can for example be implemented in a transmitter or a receiver, such as transmitter 101 or receiver 102 of Figure 1. Radiation pattern data 1200 and propagation channel data 1201 are handled in a micro controller 1202 in order to represent angular energy distribution of a wireless radio frequency propagation channel according to the invention. The radiation pattern data and propagation channel data are for example entered by a user via a keyboard comprised in I/O device 1206 or via a network interface comprised in I/O device 1206. The representation of angular energy distribution according to the particular embodiment of the invention is rendered on a screen that is comprised in I/O device 1206. The micro controller 1202 is also coupled to an antenna control unit 1205, that interfaces with an antenna system 1203 comprising one or more antennas. The antenna control unit 1205 is coupled to an RF/Digital chip 1204, which receives the antenna signals and converts them to an RSSI 12003 that that is coupled to the microcontroller 1202. The microcontroller 1202 comprises an algorithm that allows it to control the antenna control unit 1205 to select one or more antennas of the antenna system 1203, in such a way that the signal strength of signals coming from the antenna system 1203 is optimized to a desired value and/or the microcontroller 1202 modifies the antenna system 1203 properties according to known techniques, for example by modification of phasors inside the antenna control unit 1205 coupled to the antennas of the antenna system 1203.

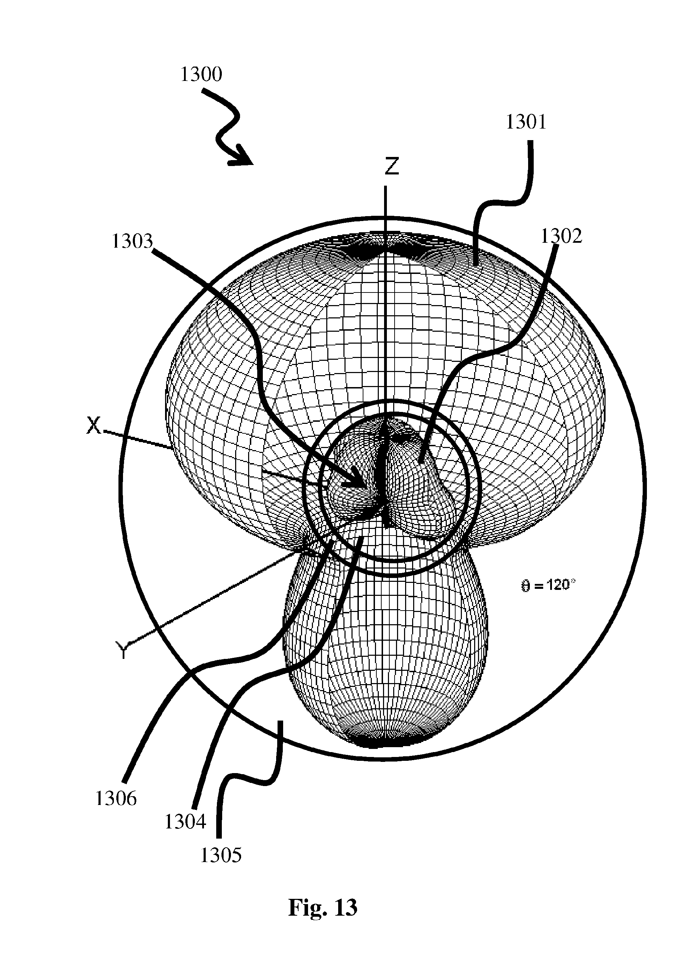

**Figure 13** shows an example of a 3D representation according to a particular embodiment of the invention. The 3D representation allows to represent angular energy distribution of a propagation channel in both the elevation plane θ and the azimuth plane φ, which is particularly advantageous for optimization of antenna systems in environments where the energy distribution is non-uniform in both planes. This figure shows a non-uniform angular energy distribution in the elevation plane, and a uniform angular energy distribution in the azimuth plane. The outer form 1301 represents the angular energy distribution of a propagation channel. The inner form 1302 represents the radiation pattern of an antenna system. As can be determined from the representation, the maximum energy distribution of the propagation channel is at an elevation angle of θ=120°. The maximum level of the radiation pattern is aligned with the maximum energy distribution of the propagation channel. This antenna system is thus rather well adapted to the angular energy distribution of the propagation channel. The figure further shows that the angular energy distribution data is represented in a first zone (1305), and that the antenna system radiation pattern is represented in a second zone (1304) and that there is an optional third empty zone 1306. The point where the X, Y and Z axis join is the origin (1303) of the spherical geometrical form 1300.

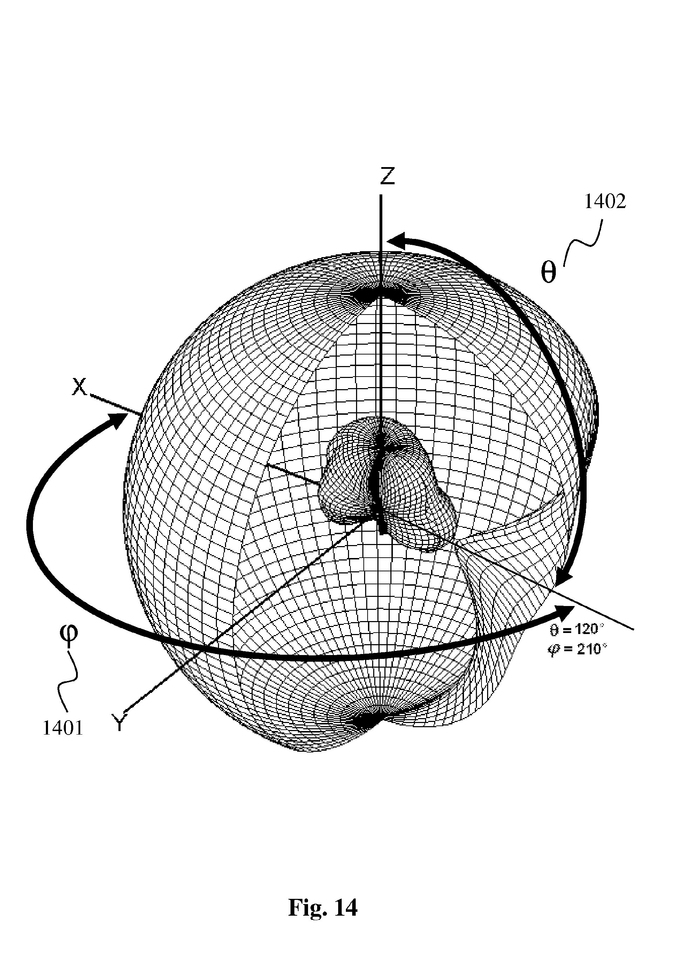

**Figure 14** shows another example of a 3D representation according to a particular embodiment of the invention. Here, the energy distribution is non-uniform in both planes. There is only one maximum energy distribution of the propagation channel, namely at elevation angle θ=120° and azimuth angle φ=210°.

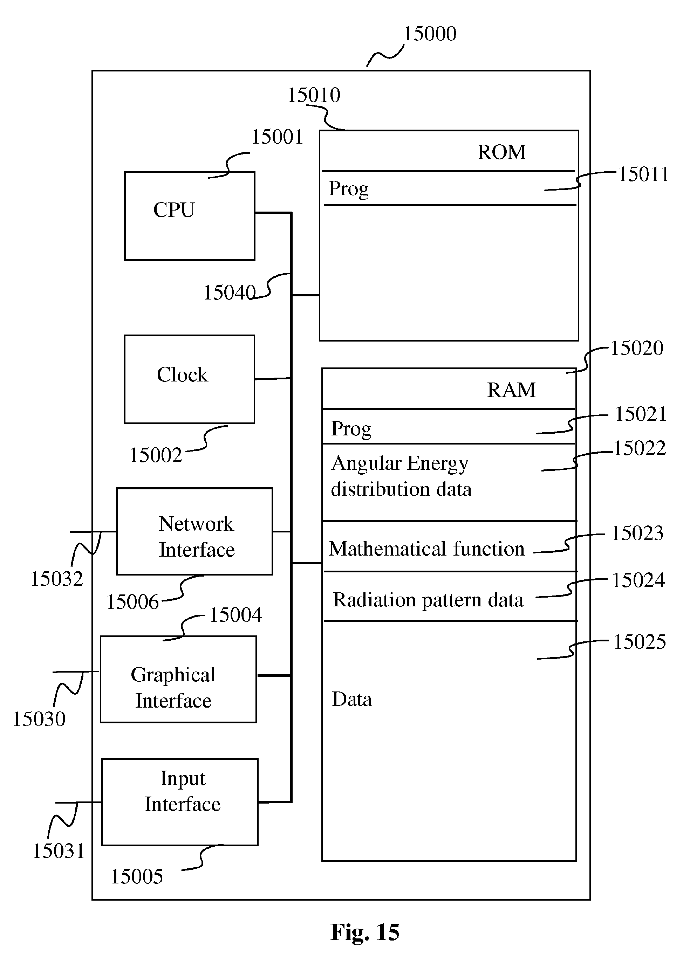

**Figure 15** shows a device 15000 implementing the method of the invention according to a particular embodiment. The device 15000 comprises the following components, interconnected by a digital data- and address bus 15040:

- a processing unit 15001 (or CPU for Central Processing Unit);
- a non-volatile memory of type ROM (Read Only Memory) 15010 ;
- a volatile memory of type RAM (Random Access Memory) 15020 ;
- a clock 15002, providing a reference clock signal for synchronization of operations between the components of the device 15000 and for timing purposes;
- a graphical interface 15004, for rendering of representations according to the particular embodiments of the invention;
- an input interface 15005, in order to receive instructions from a user;
- a network interface 15006, for connection of device 15000 to a network.

It is noted that the word "register" used in the description of memories 15010 and 15020 designates in each of the mentioned memories, a low-capacity memory zone capable of storing some binary data, as well as a high-capacity memory zone, capable of storing an executable program, or a whole data set, such as a complete data set related to angular distribution of energy in a wireless propagation channel, a complete data set related to a radiation pattern of an antenna system, or a complete mathematical function.

Processing unit 15001 can be implemented as a microprocessor, a custom chip, a dedicated (micro-) controller, and so on. ROM memory 15010 can be implemented in any form of non-volatile memory, such as a hard disk, non-volatile random-access memory, EPROM (Erasable Programmable ROM), and so on.

The ROM memory 15010 comprises notably a register 15011 that holds a program representing an executable program comprising the method for representing angular energy distribution of a wireless radio frequency propagation channel. When powered up, the processing unit 15001 loads the instructions comprised in ROM register 15011, copies them to RAM register 15021, and executes them.

The RAM memory 15020 comprises notably:

- a register 15021 comprising a copy of the program 'prog' of ROM register 15011 ;
- a register 15022 comprising data related to angular energy distribution of energy in a propagation channel;
- a register 15023 for storing of a mathematical function to apply to the data in register 15022;
- a register 15024 for storing of radiation pattern data related to an antenna system comprising one or more antennas;
- a data storage 15025 for storage of temporary results of calculation.

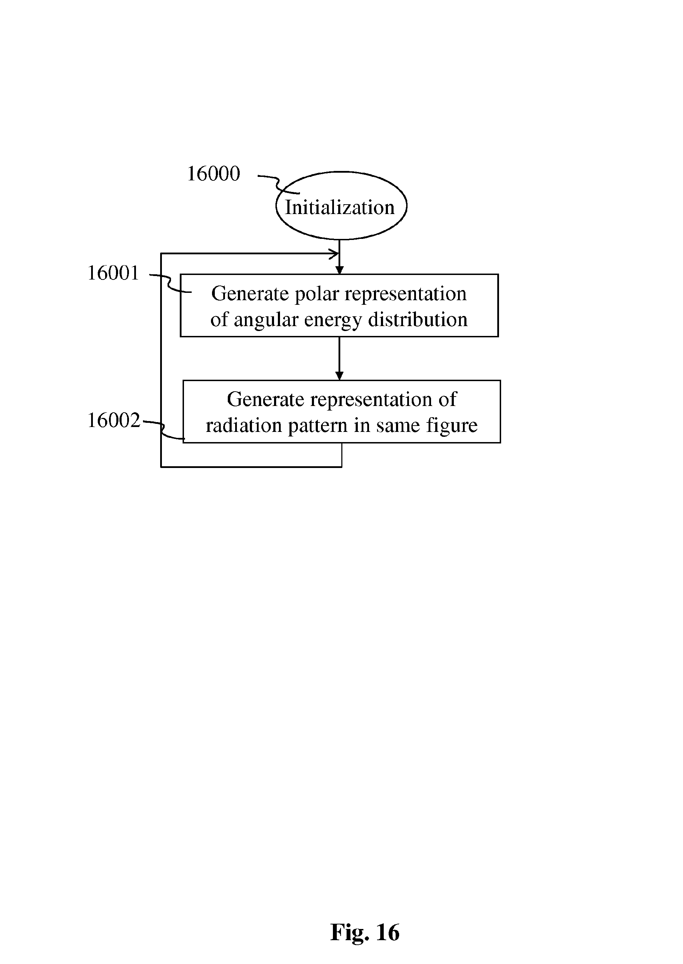

**Figure 16** shows an algorithm of the method of the invention for representing angular energy distribution data of a wireless radio frequency propagation channel according to a particular embodiment of the invention. The method is for example implemented by the device of figure 15. In a first step 16000, any variables that are needed for the algorithm are initialized. In a step 16001, a polar representation of angular energy distribution data, stored for example in register 15022 of device 15000 of Figure 15, is generated, for example by CPU 15001 of device 15000, in at least one of an azimuth or an elevation plane. This means in either one of the azimuth or elevation planes (for example according to figure 11) or in both (for example according to figure 13). This polar representation is presented in a section of a spherical geometrical form, for example fig. 11 is such a section of a spherical geometrical form, or in an entire spherical geometrical form, such as in figure 13. The polar representation is oriented according to a predetermined angular reference, for example the top of the figure represents angle θ=0°, such as is illustrated by reference 805 of figure 8. The polar representation is represented in a first zone of the section, such as in zone 802 of figure 8 or in zone 1305 of figure 13.

In a next step 16002, a representation of radiation pattern data of an antenna system is generated in (a section of) the spherical geometrical form. The radiation pattern data is for example that of antenna system 1010 or 1020 of figure 1, or 200 of figure 2, or that of mobile telephone 205 of figure 2, or 1203 of the device of figure 12.

Examples of representations that are generated according to embodiments of the invention are illustrated by Figs. 10, 11, 13 and 14.

Other device architectures than illustrated by fig 15 are possible and compatible with the method for representing angular energy distribution of a wireless radio frequency propagation channel. Notably, according to variant embodiments, the invention is implemented as a pure hardware implementation, for example in the form of a dedicated component (for example in an ASIC, FPGA or VLSI, respectively meaning Application Specific Integrated Circuit, Field-Programmable Gate Array and Very Large Scale Integration), or in the form of multiple electronic components integrated in a device or in the form of a mix of hardware and software components, for example a dedicated electronic card in a personal computer in an RF measuring device, or in a fixed or mobile RF communication device.

According to a variant embodiment of the invention, the curve represented in the first zone 802/1305 corresponds to the not inversed Cartesian representation of figure 6. With reference to figure 10, the highest energy level then points outwards, which is advantageous for representation of data related to a transmitter system. Likewise, the inversed function presentation of fig. 10, is advantageous for a receiver system, the highest energy level pointing inwards, towards the radiation pattern of the antenna system represented in the inner zone. Other mathematical functions than 1-P can be applied instead, for example -P, 1/P, etc, which depends on the scale to use: logarithmic (in decibels) or rather linear, and if the system to optimize is better understood from a reception- or a transmission point of view.

According to a variant of embodiment of the invention, the first zone overlaps the second zone, for very simple antenna systems and/or very simple propagation channel representation, for example in case of a uniform energy distribution in both orthogonal planes, or in case of Line Of Sight energy distribution for a satellite link.

The method and device according to the invention is suitable for transmitter- and receiver systems that use transmission standards such as WiFi, WiMAX, mobile communication standards such as GSM, DCS, AMP, UMTS, LTE, GRPS, EDGE, and television/radio transmission/reception standards such as DVB-T DVB-H and ATSC.

**Claims**

1. Method for representing angular energy distribution data of a wireless radio frequency propagation channel, **characterized in that** said method represents said angular energy distribution data as related to radiation pattern data of an antenna system (1010, 1020, 200) comprising at least one antenna, said method comprising the following steps:

   - generating a polar representation of said angular energy distribution data in at least one of an azimuth or an elevation plane, said polar representation being presented in a first zone (802, 1305) of at least a section of a spherical geometrical form (803, 1300), said polar representation being oriented according to a predetermined angular reference (805, 1401, 1402);
   - generating, in said at least a section of said spherical geometrical form (803, 1300), of a representation of said radiation pattern data (1000, 1100, 1101, 1302) of said antenna system (1010, 1020, 200) as oriented according to said predetermined angular reference (805, 1401, 1402).

2. Method according to claim 1, said method being further **characterized in that** it comprises:

   - representing said radiation pattern data (1000, 1100, 1101, 1302) of said antenna system (1010, 1020, 200) in a second zone (800, 1304) centered in an origin (804, 1303) of said at least one section of said spherical geometrical form (803, 1300);

- said first zone (802, 1305) being situated around said second zone (800, 1304), said first zone (802, 1305) being centered in said origin (804, 1303) of said at least one section of said spherical geometrical form (803, 1300).

3. Method according to claims 1 or 2, **characterized in that** said polar representation of said angular energy distribution data is determined according to at least one predetermined mathematical function applied to said angular energy distribution data.

4. Method according to any of claims 1 to 3, **characterized in that** the method further comprises:

- rendering of an empty zone (801, 1306) between said first zone (802, 1305) and said second zone (800, 1304), said empty zone (801, 1306) being centered in said origin (804, 1303) of said at least one section of said spherical geometrical form (803, 1300).

5. Device (15000, 1210) for representing angular energy distribution data of a wireless radio frequency propagation channel, **characterized in that** said device represents said angular energy distribution data as related to radiation pattern data of an antenna system (1010, 1020, 200) comprising at least one antenna, said device (15000, 1210) comprising the following means:

- means (15001, 1202) for generating a polar representation of said angular energy distribution data in at least one of an azimuth or an elevation plane, said polar representation being presented in a first zone (802, 1305) of at least a section of a spherical geometrical form (803, 1300), said polar representation being oriented according to a predetermined angular reference (805, 1401, 1402);
- means (15001, 1202) for generating in said at least a section of said spherical geometrical form (803, 1300), of a representation of said radiation pattern data (1000, 1100, 1101, 1302) of said antenna system (1010, 1020, 200) as oriented according to said predetermined angular reference (805, 1401, 1402).

6. Device (15000, 1210) according to claim 5, **characterized in that** said device (15000, 1210) further comprises means (15001, 1202) for representing said radiation pattern data (1000, 1100, 1101, 1302) of said antenna system (1010, 1020, 200) in a second zone (800, 1304) centered in an origin (804, 1303) of said at least one section of said spherical geometrical form (803, 1300), and means (15001, 1202) for rendering said first zone (802, 1305) around said second zone (800, 1304), said first zone (802, 1305) being centered in said origin (804, 1303) of said at least one section of said spherical geometrical form (803, 1300).

7. Device (15000, 1210) according to claims 5 or 6, **characterized in that** said polar representation of said angular energy distribution data is determined by determination means (15001, 1202) according to at least one predetermined mathematical function applied to said angular energy distribution data.

Source ⌇100

1000⌇ ⌇1010

1020⌇

Transmitter ⌇1001

Receiver

Propagation channel

⌇101 102⌇

**Fig. 1**

204⌇

2000

200⌇ 2001

203⌇

205⌇

2003

201⌇

2002

202⌇

**Fig. 2**

**Fig. 3**

**Fig. 4**

**Fig. 5**

600

**Fig. 6**

**Fig. 7**

803

805

Θ = 0°

Θ = -60°

Θ = 60°

804

Θ = 270°

Θ = 90°

800

801

Θ = 180°

802

**Fig. 8**

Fig. 9

**Fig. 10**

**Fig. 11**

1210

1200        1201

| Radiation Pattern data | Channel model data |

12001        12002        1203

1202

12000        µcontroller

12005

12003

I/O devices        RF/Digital Chip        Antenna control unit (switch, phasor ...)

12004

1206        1204        1205

**Fig. 12**

Fig. 13

**Fig. 14**

15000

15010

15001

15011

CPU

ROM

Prog

15040

Clock

15002

15020

RAM

Prog

15021

Angular Energy
distribution data

15022

Network
Interface

Mathematical function

15023

15032

Radiation pattern data

15024

15006

15004

15025

15030

Graphical
Interface

Data

15031

Input
Interface

15005

**Fig. 15**

16000

Initialization

16001 — Generate polar representation
of angular energy distribution

16002 — Generate representation of
radiation pattern in same figure

**Fig. 16**

| | Europäisches Patentamt European Patent Office Office européen des brevets | **EUROPEAN SEARCH REPORT** | Application Number EP 10 30 5691 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/299717 A1 (ZHAO XUEYUAN [HK] ET AL) 3 December 2009 (2009-12-03) * the whole document * | 1-7 | INV. G01R29/08 G01R29/10 H04B17/00 |
| X | WO 2009/046516 A1 (EMSCAN CORP [CA]; NYSHADHAM ADISESHU [CA]; PATTON RUSKA [CA]; JIN JASO) 16 April 2009 (2009-04-16) * the whole document * | 1-7 | |
| X | WO 2005/122328 A2 (INTERDIGITAL TECH CORP [US]; CHIANG BING A [US]; CHA INHYOK [US]; LYNC) 22 December 2005 (2005-12-22) * paragraphs [0001], [0018] - [0020], [0033], [0043] - [0048], [0051], [0057] - [0060]; figures 3,8 * | 1-7 | |
| X | GUTERMAN J ET AL: "Wrapped Microstrip Antennas for Laptop Computers", IEEE ANTENNAS AND PROPAGATION MAGAZINE, IEEE SERVICE CENTER, PISCATAWAY, NJ, US, vol. 51, no. 4, 1 August 2009 (2009-08-01) , pages 12-39, XP011285011, ISSN: 1045-9243, DOI: DOI:10.1109/MAP.2009.5338680 * the whole document * | 1-7 | |
| X | US 2006/269020 A1 (VICHARELLI PABLO A [US] ET AL) 30 November 2006 (2006-11-30) * the whole document * | 1-7 | TECHNICAL FIELDS SEARCHED (IPC) G01R H04B |

-/--

The present search report has been drawn up for all claims

| Place of search | Date of completion of the search | Examiner |
|---|---|---|
| Berlin | 25 November 2010 | Binger, Bernard |

EPO FORM 1503 03.82 (P04C01)

Europäisches
Patentamt

European
Patent Office

Office européen
des brevets

# EUROPEAN SEARCH REPORT

Application Number

EP 10 30 5691

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FORENZA A ET AL: "Optimization methodology for designing 2-CPAs exploiting pattern diversity in clustered MIMO channels", IEEE TRANSACTIONS ON COMMUNICATIONS, IEEE SERVICE CENTER, PISCATAWAY, NJ, US, vol. 56, no. 10, 1 October 2008 (2008-10-01), pages 1748-1759, XP011236207, ISSN: 0090-6778, DOI: DOI:10.1109/TCOMM.2008.060582 * the whole document * | 1-7 | |
| X | WO 2007/127955 A2 (RAYSPAN CORP [US]; ACHOUR MAHA [US]; GUMMALLA AJAY [US]; STOYTCHEV MAR) 8 November 2007 (2007-11-08) * paragraphs [0079] - [0089], [0192] - [0197]; figures 9b,10,16e,18d,19d,24 * | 1-7 | |

TECHNICAL FIELDS
SEARCHED        (IPC)

The present search report has been drawn up for all claims

| Place of search | Date of completion of the search | Examiner |
|---|---|---|
| Berlin | 25 November 2010 | Binger, Bernard |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.............................................................................................

& : member of the same patent family, corresponding
    document

EPO FORM 1503 03.82 (P04C01)

EP 2 400 311 A1

## ANNEX TO THE EUROPEAN SEARCH REPORT
## ON EUROPEAN PATENT APPLICATION NO.

EP 10 30 5691

25-11-2010

| Patent document cited in search report | | Publication date | Patent family member(s) | | Publication date |
|---|---|---|---|---|---|
| US 2009299717 | A1 | 03-12-2009 | NONE | | |
| WO 2009046516 | A1 | 16-04-2009 | CN | 101652667 A | 17-02-2010 |
| | | | GB | 2460003 A | 18-11-2009 |
| WO 2005122328 | A2 | 22-12-2005 | EP | 1766722 A2 | 28-03-2007 |
| | | | JP | 4542141 B2 | 08-09-2010 |
| | | | JP | 2008502226 T | 24-01-2008 |
| | | | US | 2005285784 A1 | 29-12-2005 |
| US 2006269020 | A1 | 30-11-2006 | NONE | | |
| WO 2007127955 | A2 | 08-11-2007 | EP | 2022134 A2 | 11-02-2009 |
| | | | JP | 2009535942 T | 01-10-2009 |
| | | | KR | 20090014279 A | 09-02-2009 |
| | | | US | 2008258981 A1 | 23-10-2008 |
| | | | US | 2010283692 A1 | 11-11-2010 |
| | | | US | 2010283705 A1 | 11-11-2010 |